(19) Europäisches Patentamt
European Patent Office
Office européen des brevets

(11) EP 1 103 858 B1

(12) **FASCICULE DE BREVET EUROPEEN**

(45) Date de publication et mention de la délivrance du brevet:
**30.11.2005 Bulletin 2005/48**

(51) Int Cl.[7]: **G03F 7/20**, H01L 23/525, H01L 21/033

(21) Numéro de dépôt: **01104110.0**

(22) Date de dépôt: **14.05.1999**

(54) **Procédé de réalisation par photolithographie de fusible de circuit intégré à point de claquage localisé**

Photolithographisches Verfahren zur Herstellung einer mit-lokalisiertem-Schmelzpunkt-Sicherung in einer integrierten Schaltung

Photolithographic method to make a fuse in integrated circuit with localised blowing point

(84) Etats contractants désignés:
**DE FR GB IT**

(30) Priorité: **14.05.1998 FR 9806071**

(43) Date de publication de la demande:
**30.05.2001 Bulletin 2001/22**

(62) Numéro(s) de document de la (des) demande(s) initiale(s) en application de l'article 76 CBE:
**99401181.5 / 0 957 403**

(73) Titulaire: **STMicroelectronics S.A.**
**92120 Montrouge (FR)**

(72) Inventeurs:
- **Delpech, Philippe, Cabinet Ballot**
  **83000 Toulon (FR)**
- **Revil, Nathalie, Cabinet Ballot**
  **83000 Toulon (FR)**

(74) Mandataire: **Bentz, Jean-Paul et al**
**CABINET BALLOT**
**Groupe NOVAGRAAF**
**122, rue Edouard Vaillant**
**92593 Levallois Perret Cedex (FR)**

(56) Documents cités:
**EP-A- 0 313 815**
**US-A- 4 895 780**
**US-A- 5 208 124**
**US-A- 5 708 291**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 1 103 858 B1

Printed by Jouve, 75001 PARIS (FR)

## Description

La présente invention concerne le domaine des circuits intégrés et plus particulièrement un fusible de circuit intégré.

La prévision de fusibles dans les circuits intégrés est une pratique courante pour l'homme de l'art, notamment dans le cadre de la fabrication des circuits MOS. Par exemple, il est classique de prévoir des fusibles pour protéger des grilles de transistors MOS contre l'accumulation de charges électrostatiques apparaissant pendant la fabrication des circuits intégrés. Ces fusibles sont ensuite claqués pour libérer les grilles des transistors. Comme autre exemple, la prévision de lignes de mots ou de lignes de bits redondantes dans les mémoires à grande capacité repose également sur l'utilisation de fusibles, les lignes défectueuses ou inutilement redondantes étant ensuite isolées du reste de la mémoire par claquage de fusibles.

Ainsi, de façon générale, les fusibles présents dans les circuits intégrés sont destinés à être grillés par application d'une tension ou d'un courant de claquage, et permettent de modifier la configuration d'un circuit à un stade final de fabrication.

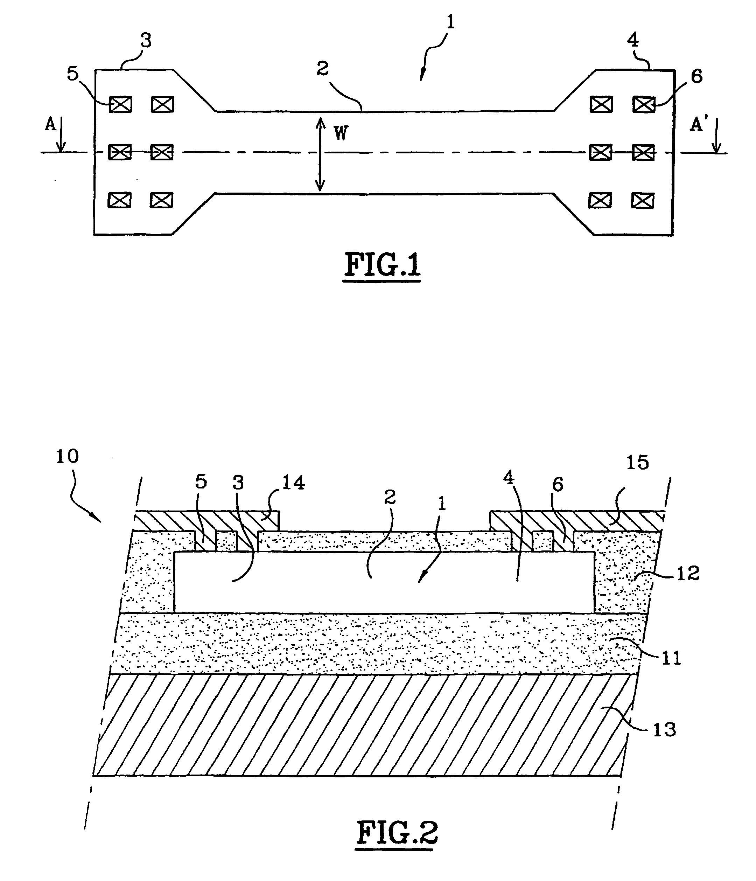

La présente invention concerne plus particulièrement un fusible réalisé par gravure, du type représenté sur la figure 1. Un tel fusible 1, d'une structure très simple et d'un faible encombrement, comprend une région centrale 2 en forme de barreau s'épanouissant à ses extrémités pour former deux plages 3, 4 recevant une pluralité de contacts électriques 5, 6. En général, comme représenté sur la figure 2 par une vue en coupe, le fusible 1 est enterré dans un circuit intégré 10 où il se trouve pris en sandwich entre une couche inférieure 11 et une couche supérieure 12 d'oxyde déposées sur un substrat de silicium 13. Les contacts 5,6 prennent la forme d'orifices métallisés traversant la couche d'oxyde 12 pour relier les plages 3, 4 à des conducteurs 14, 15. Classiquement, l'ensemble est réalisé par dépôt successif de diverses couches d'oxyde, de métal et/ou de polysilicium et gravure des couches par photolithographie.

Afin que la densité de courant dans le fusible 1 et l'efficacité du claquage soient maximales pour un courant de claquage donné, il est d'usage que la largeur W de la région centrale 2 du fusible soit choisie égale au minimum technologique $W_{min}$ autorisé par la technologie de fabrication du circuit intégré 10. A titre d'exemple, il est courant à l'heure actuelle que le minimum technologique $W_{min}$ des circuits intégrés de type MOS soit de l'ordre de 0,25 micromètre en ce qui concerne la largeur minimale d'un conducteur (soit la longueur minimale des grilles des transistors MOS).

Cette précaution ne représente toutefois qu'un avantage relatif étant donné que le minimum technologique détermine également la taille des autres composants présents dans le circuit intégré 10, notamment des transistors, et leur capacité à résister aux tensions ou aux courants élevés. Ainsi, ces dernières années, la diminution du minimum technologique grâce au perfectionnement des technologies est allée de pair avec une diminution des tensions et courants de claquage admissibles. A titre d'exemple, les tensions de claquage maximales autorisées dans les circuits MOS à moyenne intégration de technologie ancienne sont de l'ordre de 5,5 à 6 Volt et ne sont plus que de 1,8 à 2 Volt avec les circuits à forte intégration de dernière génération.

Ainsi, malgré la prévision d'une largeur minimale, un fusible classique n'offre pas, statistiquement, un rendement de claquage égal à 100 % dans des conditions standard de claquage. En d'autres termes, lorsque l'on cherche à claquer simultanément un ensemble de fusibles présents dans un circuit intégré en appliquant une ou plusieurs impulsions de claquage, de courant ou de tension, il est fréquent qu'il subsiste des fusibles non claqués. Ces fusibles présentent une résistance électrique qui, bien que plus élevée que leur résistance électrique initiale, n'est pas assimilable à un circuit ouvert.

Il va de soi que cet inconvénient se répercute sur le rendement de fabrication des circuits intégrés et devient rédhibitoire lorsque l'on prévoit dans un même circuit intégré plusieurs dizaines voire plusieurs centaines de fusibles.

Le brevet US-5,608,257 décrit un fusible de circuit intégré d'un autre genre qui est destiné à être claqué par un spot laser.

La jonction fusible comporte un segment joignant deux plages d'interconnexion, le segment comportant plusieurs ailettes transversales et une ou deux sections, de largeur inférieure au segment du fusible, intercalés entre les ailettes.

Les ailettes ont pour fonction de maximiser la surface d'absorption d'énergie du spot laser et d'éviter toute atteinte au substrat sous-jacent.

Comparativement l'étranglement de la section du fusible permet de réduire la quantité de matière, donc la quantité d'énergie lumineuse nécessaire au claquage. Ces dispositions ont donc pour but d'améliorer le transfert énergétique et l'efficacité du claquage par laser.

D'autre part dans une variante particulière de ce fusible du brevet US-5, 608, 257, on dispose des éléments postiches linéaires de chaque côté du fusible, parallèlement au segment central. Les éléments postiches sont disposés aux extrémités des ailettes, dans l'espace séparant deux fusibles, à distance de chaque section étranglée dont la largeur est conservée. La largeur de l'étranglement du fusible reste donc supérieure à la largeur minimum des pistes du circuit intégré.

Ces éléments postiches sont prévus, en cas de mauvais alignement du spot laser entre deux fusibles, pour absorber l'énergie du laser et être claqués, toujours afin de protéger le substrat sous-jacent.

L'inconvénient rédhibitoire du claquage de fusible par laser reste en effet de nécessiter des étapes spéciales de traitement optique avec un alignement optique du laser très délicat contrairement à l'aisance du claquage électrique.

En outre on ne peut pas toujours envisager d'accéder optiquement de l'extérieur par des pistes de fusibles de circuit intégré, les pistes de circuits intégrés étant couvertes par des couches de protection.

Le document US-5,709,291 propose un fusible destiné à être claqué électriquement et comportant des plages de contacts reliées par un barreau, dont la largeur est proche, mais supérieure à la limite inférieure du processus technologique utilisé.

Ce document US-5,708,291 publié en janvier 1998, fait état d'un minimum technologique d'environ 0,22 micromètre, mais ne fait état d'aucun moyen pour abaisser cette limite inférieure.

Le minimum technologique Wmin représente donc un obstacle dans la recherche d'un fusible présentant un bon rendement de claquage. Il est connu dans le domaine de la photolithographie que le minimum technologique Wmin est déterminé par diverses contraintes technologiques, notamment l'obtention d'une fiabilité satisfaisante des grilles des transistors MOS et par ailleurs un phénomène de diffraction et de réflexion de lumière au moment de l'insolation des masques de gravure en résine organique, appelé par l'homme de l'art "effet optique de proximité".

Enfin, un autre inconvénient des fusibles classiques est de n'être pas entièrement fiables, un certain pourcentage de fusibles claqués ayant tendance à se régénérer, pour des raisons encore mal expliquées. En pratique, la régénération d'un fusible se traduit par le fait que ses propriétés d'isolement électrique se dégradent alors qu'elles étaient initialement satisfaisantes.

Ainsi, un objectif général de la présente invention est de prévoir un fusible de circuit intégré qui soit susceptible de claquer plus facilement qu'un fusible classique de même encombrement traversé par un courant identique.

Un autre objectif de la présente invention est de prévoir un fusible offrant un rendement de claquage supérieur aux fusibles classiques et une meilleure fiabilité.

Un objectif plus particulier de la présente invention est de prévoir un fusible de circuit intégré d'une largeur inférieure à un minimum technologique, et un procédé de fabrication d'un tel fusible.

Ces objectifs sont atteints par la prévision d'un fusible de circuit intégré comprenant une région centrale sensiblement en forme de barreau et des plages comportant des contacts électriques, dans lequel la région centrale comporte une zone amincie de moindre largeur formant un point faible facilitant le claquage du fusible par augmentation de la densité locale de courant dans des conditions standard de claquage.

L'invention est obtenue avec un procédé de réalisation par photolithographie de circuit intégré disposant d'au moins un fusible comprenant des plages comportant des contacts électriques et une région centrale sensiblement en forme de barreau comportant une région amincie formant un point faible facilitant le claquage du fusible par augmentation de la densité de courant dans des conditions standards de claquage, le procédé comportant des étapes consistant à :

- former un masque d'insolation reproduisant un dessin de fusible comportant la région centrale (D2) en forme de barreau, en disposant au moins un élément factice à proximité de la région centrale ayant un bord disposé, par rapport au bord correspondant de la région centrale, à une distance inférieure au seuil technologique en dessous duquel se manifeste l'effet optique de proximité, et
- former, par insolation à travers le masque d'insolation, un masque de gravure de fusible dont la région centrale fait apparaître une zone amincie par effet optique de proximité, de sorte que la largeur de la zone amincie est inférieure à un minimum technologique déterminé par la technologie de fabrication du circuit intégré.

Il est prévu que chaque élément factice a un bord disposé par rapport au bord correspondant de la région centrale, à une distance inférieure au seuil technologique en dessous duquel se manifeste l'effet optique de proximité.

Selon un mode de réalisation, la région centrale du dessin de fusible a une largeur choisie pour obtenir une largeur de fusible sensiblement égale au minimum technologique, en dehors de la zone amincie.

Selon un mode de réalisation, la largeur) de la zone amincie est sensiblement égale à la moitié de la largeur moyenne de la région centrale en dehors de la zone amincie.

Avantageusement, l'effet optique de proximité forme un amincissement progressif de la région centrale.

Avantageusement, l'effet optique de proximité forme, entre la région centrale et la zone amincie, des transitions d'amincissement présentant des bords obliques.

De préférence, sur le dessin du fusible, on dispose deux éléments factices de part et d' autre de la zone amincie.

De préférence il est prévu de former encoches sur les flancs de la région centrale du fusible.

Avantageusement, en utilisant l'effet optique de proximité, le masque de gravure de fusible présente au moins une ouverture de gravure de largeur supérieure à la largeur d'espacement entre les éléments prévue sur le dessin de fusible du masque d'insolation.

Selon un mode de réalisation, le masque de gravure est obtenu par dépôt d'une couche de résine photosensible sur une couche du circuit intégré, suivi d'une étape d'insolation de la résine par l'intermédiaire du masque d'insolation et d'une étape de retrait de la résine insolée au moyen d'un solvant.

Selon un mode de réalisation, le fusible de circuit intégré est réalisé par gravure d'une couche mince de polysilicium, de métal ou d'alliage, ou encore par gravure d'une couche mince formée d'un empilement de métaux ou d'alliages.

Selon un mode de réalisation, le fusible de circuit intégré est réalisé en polysilicium siliciuré.

Il est prévu une étape de gravure au plasma.

Avantageusement, la disposition d'éléments factices favorise la gravure d'une couche d'oxyde sur les flancs du fusible, de sorte que le fusible présente des espaceurs d'oxyde ne recouvrant pas entièrement les flancs de la zone amincie.

Selon un mode de réalisation, les contacts sont des orifices métallisés traversant une couche d'oxyde recouvrant le fusible pour relier les plages du fusible à des éléments conducteurs.

Selon un mode de réalisation, l'augmentation de la résistance électrique de la région centrale due à la prévision de la zone amincie est négligeable devant la résistance totale du fusible, la résistance totale comprenant une résistance d'accès au fusible, la résistance d'accès comprenant la résistance électrique d'éléments conducteurs et la résistance électrique des contacts.

Ces objets, caractéristiques et avantages ainsi que d'autres de la présente invention seront exposés plus en détail dans la description suivante d'un exemple de réalisation d'un fusible selon l'invention et d'un procédé permettant de réaliser un tel fusible, faite à titre non limitatif en relation avec les figures jointes parmi lesquelles:

- la figure 1 précédemment décrite est une vue de dessus d'un fusible classique
- la figure 2 précédemment décrite est une vue en coupe selon un axe AA' du fusible de la figure 1 agencé dans un circuit intégré,
- la figure 3 est une vue de dessus d'un fusible selon l'invention,
- la figure 4 est le schéma électrique équivalent du fusible de la figure 3,
- les figures 5A à 5C représentent des étapes classiques de photolithographie, allant de la conception à la réalisation d'une gravure à la surface d'un circuit intégré,
- les figures 6A à 6C représentent pour une gravure de moindre largeur les mêmes étapes que les figures 5A à 5C et illustrent un phénomène appelé "effet optique de proximité",
- la figure 7 représente le dessin initial d'un fusible selon l'invention,
- la figure 8 représente le fusible obtenu à partir du dessin de la figure 7, et
- la figure 9 est une vue partielle en coupe selon un axe BB' du fusible de la figure 8 agencé dans un circuit intégré.

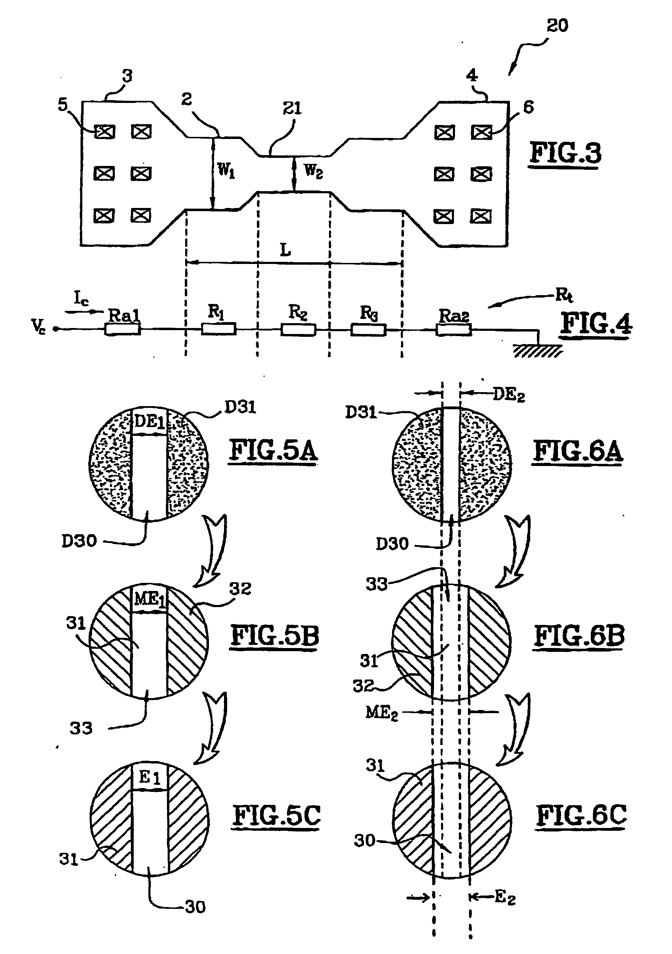

La figure 3 représente par une vue de dessus un fusible 20 selon la présente invention. Dans sa forme générale, le fusible 20 a l'aspect du fusible classique de la figure 1. Le fusible 20 comporte ainsi une région centrale 2 sensiblement en forme de barreau, ici d'une longueur L égale au triple de sa largeur W1, et des plages 3, 4 pourvues de contacts 5, 6, les références de ces divers éléments étant conservées. Le fusible 20 est réalisé par gravure d'une couche mince de polysilicium, de métal ou d'alliage, ou encore par gravure d'une couche mince formée d'un empilement de métaux ou d'alliages.

Selon l'invention, la région centrale 2 du fusible 20 présente un rétrécissement, ou zone amincie 21, de largeur W2 inférieure à la largeur moyenne W1 de la région centrale. La largeur W2 est par exemple égale à la moitié de la largeur W1, comme représenté sur la figure 3. La zone amincie 21 occupe une faible partie de la longueur L de la région centrale 2, par exemple un tiers de la longueur L, et est de préférence agencée à mi-distance des plages 3, 4.

Avantageusement, la zone amincie 21 présente une forte densité de courant dans des conditions standard de claquage, par exemple pour un courant de claquage donné, et forme un point faible facilitant le claquage du fusible. Plus particulièrement, la forte concentration de courant rend le claquage plus explosif et plus efficace, et le fusible selon l'invention offre un meilleur rendement de claquage et une probabilité de régénération plus faible qu'un fusible classique.

La zone amincie 21 permet par ailleurs de localiser le point d'éclatement du fusible et d'éloigner ce point des plages 5, 6 où se trouve une plus grande quantité de matière conductrice. Selon la demanderesse, et sous réserve d'études complémentaires devant être conduites sur les mécanismes de régénération des fusibles, cet aspect de l'invention est susceptible de contribuer à l'obtention d'une faible probabilité de régénération du fusible et par conséquent d'améliorer sa fiabilité.

De plus, la résistance électrique totale Rt du fusible n'est pas augmentée de façon significative par rapport à un fusible de l'art antérieur de même dimension, de sorte que l'on bénéficie d'un même courant de claquage pour une tension de claquage donnée (ou inversement). Cet avantage repose sur le fait qu'en pratique la résistance totale du fusible, c'est-à-dire la résistance mesurable depuis les plots externes d'un circuit intégré, est égale à la somme de la résistance de la région centrale 2 et d'une résistance d'accès au fusible qui n'est pas négligeable. A titre d'exemple numérique, la résistance de la région centrale d'un fusible est classiquement de l'ordre de 1 à 10 Ω, selon la forme du fusible et les matériaux utilisés, alors que la résistance d'accès, comprenant la résistance de conducteurs menant au fusible et la résistance des contacts 5, 6, est de l'ordre de 11 Ω.

Ainsi, comme représenté en figure 4, la résistance électrique totale Rt du fusible 20 peut être considérée comme égale à la somme de cinq résistances Ra1, Ra2, R1, R2, R3 en série traversées par un courant de claquage Ic. Les résistances R1, R3 représentent la résistance de la région centrale 2 de part et d'autre de la zone amincie 21 et sont ici sensiblement égales à la résistance $R_0$ par unité de surface du matériau constituant le fusible. La résistance R2 représente la résistance de la zone amincie 21 et est ici sensiblement égale à $2R_0$. Les résistances Ra1 et Ra2 sont les résistances d'accès aux deux extrémités du fusible. La résistance totale Rt du fusible 20 est ainsi égale à :

$$Ra1 + Ra2 + 4\ R_0$$

alors que la résistance totale d'un fusible classique de même forme et dimension est égale à :

$$Ra1 + Ra2 + 3\ R_3$$

La résistance $R_0$ étant généralement faible devant la résistance d'accès Ra, il vient que le rapport Ic/Vc entre courant Ic et tension Vc de claquage n'est sensiblement pas modifié par la prévision de la zone amincie 21.

Par ailleurs, selon un autre aspect de l'invention, on propose de diminuer la largeur W2 de la zone amincie 21 en dessous d'un minimum technologique $W_{min}$, en tirant profit du phénomène appelé effet optique de proximité intervenant dans les procédés de gravure par photolithographie. On va tout d'abord rappeler, pour fixer les idées, comment ce phénomène se manifeste au cours d'un processus de gravure.

La figure 5C est une vue partielle d'une gravure 30 à bords parallèles, de largeur E1, réalisée par exemple dans une couche de polysilicium 31. La figure 5A représente le dessin initial de cette gravure, tel que prévu par un concepteur de circuit intégré, les références de la figure 5C étant précédées de la lettre "D" sur la figure 5A.

Dans cet exemple, on considère que la largeur DE1 de la gravure D30 telle que dessinée est choisie supérieure à un seuil technologique SEmin. Ce seuil technologique représente l'espace minimum entre deux éléments en dessous duquel se manifeste l'effet optique de proximité.

L'étape de dessin illustrée par la figure 5A est suivie de diverses étapes classiques comme la réalisation d'un masque d'insolation reproduisant le dessin initial et la réalisation d'un masque de gravure. La figure 5B représente le masque de gravure 32 correspondant au dessin de la figure 5A. Le masque 32 est obtenu par dépôt d'une couche de résine photosensible sur la couche de polysilicium 31, suivi d'une étape d'insolation de la résine par l'intermédiaire du masque d'insolation, et d'une étape de retrait de la résine insolée au moyen d'un solvant. Au final, le masque 31 présente une ouverture 33 qui laisse apparaître le polysilicium 31, dont la largeur ME1 est égale à la largeur DE1 prévue sur le dessin initial. Après l'étape de gravure du polysilicium, en général une gravure au plasma, la largeur E1 de la zone gravée 30 (fig. 5C) est elle aussi égale à la largeur prévue DE1 (en pratique, la zone gravée représente l'espace entre deux lignes de polysilicium).

Les figures 6A à 6C représentent avec les mêmes références les mêmes étapes de processus, la largueur dessinée DE2 de la gravure D30 étant maintenant choisie inférieure au seuil technologique SEmin. Comme on le voit en figure 6B, il en résulte que le masque de gravure 32 présente une ouverture 33 plus importante que prévu, de largeur ME2 supérieure à la largeur DE2 prévue sur le dessin. Ainsi, sur la figure 6C, la gravure 30 présente également une largeur E2 supérieure à celle prévue sur le dessin.

Comme cela est bien connu de l'homme de l'art, cet élargissement est principalement dû à des phénomènes de réfraction et de réflexion de lumière au moment de l'insolation du masque de gravure, et marque les limites d'une technologie donnée. Bien entendu, l'effet optique de proximité se manifeste également lorsque l'on veut réaliser une bande étroite de matière par gravure de la matière environnante, ce qui définit un seuil technologique Swmin en largeur d'élément, en dessous duquel les dimensions dessinées sont altérées. Par ailleurs, en relation avec d'autres contraintes technologiques comme la fiabilité des circuits intégrés, l'effet optique de proximité détermine également un minimum technologique Emin en largeur de gravure (espace minimum entre deux éléments) ainsi qu'un minimum technologique Wmin en largeur d' élément (largeur minimum d'un élément), déjà cité au préambule. Les minima technologiques Wmin, Emin sont généralement inférieurs aux seuils technologiques Swmin, SEmin et sont obtenus grâce à des corrections de dessin visant à compenser l'effet optique de proximité. De telles solutions sont présentées dans les brevets US 4,895,780 et US 5,208,124. Le brevet US 4,895,780 propose un masque en substrat transparent comprenant une pluralité de dessins de base opaques selon une radiation, et le brevet US 5,208,124 propose un procédé de fabrication d'un masque de compensation de l'effet optique de proximité, consistant tout d'abord à générer un masque original, puis à ajuster ce masque original par réduction successive de la taille des dessins opaques.

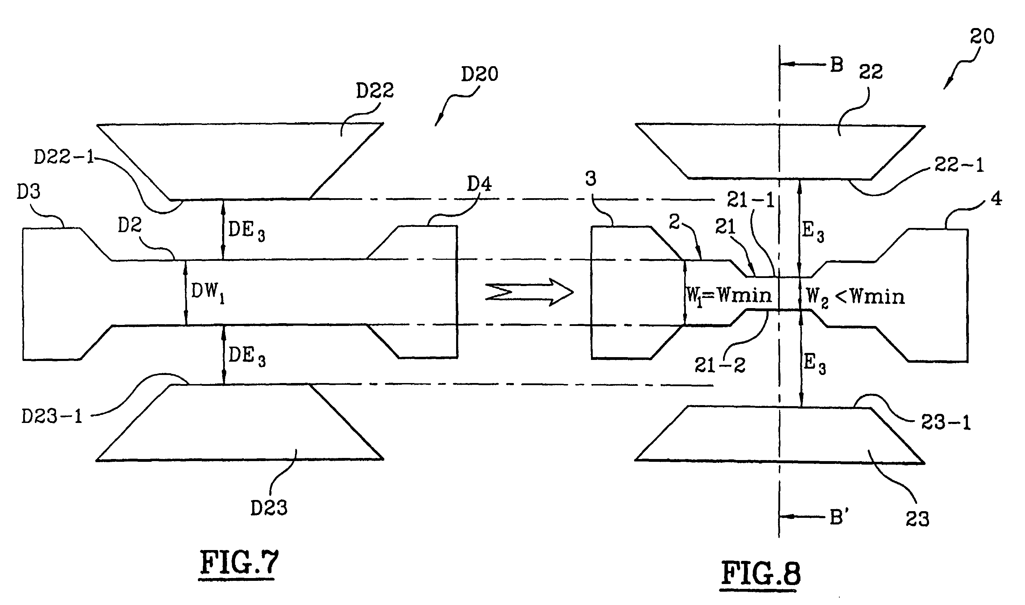

On se reportera maintenant aux figures 7 et 8 qui illustrent un procédé selon l'invention permettant de réaliser un fusible 20 ayant une zone amincie 21 de largeur W2 inférieure au minimum technologique Wmin.

La figure 7 représente le dessin D20 du fusible 20 selon l'invention et la figure 8 représente le fusible 20 obtenu après gravure d'une couche de polysilicium, de métal ou d'alliage, les références de la figure 8 étant précédées de la lettre "D" sur la figure 7. Selon l'invention, le fusible D20 tel que dessiné ne comprend pas de zone amincie mais comporte de part et d'autre de la région centrale D21 deux éléments factices D22, D23 polygonaux. Chaque élément factice D22, D23 présente un bord D22-1, D23-1 parallèle à la région centrale D2, à une distance DE3 de celle-ci. La distance DE3 est volontairement inférieure au seuil technologique SEmin décrit plus haut. Par ailleurs, de préférence, la largeur DW1 de la région centrale D2 est choisie pour obtenir une largeur de fusible égale au minimum technologique Wmin.

Comme on le voit en figure 8, le résultat final après gravure est que la distance E3 entre les bords 22-1, 23-1 des éléments factices et les bords de la région centrale 2 est augmentée par effet optique de proximité, de sorte que l'on a perdu un peu de matière sur les éléments factices 22, 23 et un peu de matière sur les bords de la région centrale 2 en regard des éléments factices 22,23. La matière enlevée sur les bords de la région centrale 2 forme deux encoches symétriques 21-1, 21-2 faisant apparaître la zone amincie 21, dont la largeur W2 est inférieure au minimum technologique Wmin.

En repoussant ainsi les limites imposées par la technologie, on augmente de façon encore plus sensible la densité du courant de claquage dans la zone amincie, et par conséquent le rendement de claquage et la fiabilité du fusible selon l'invention.

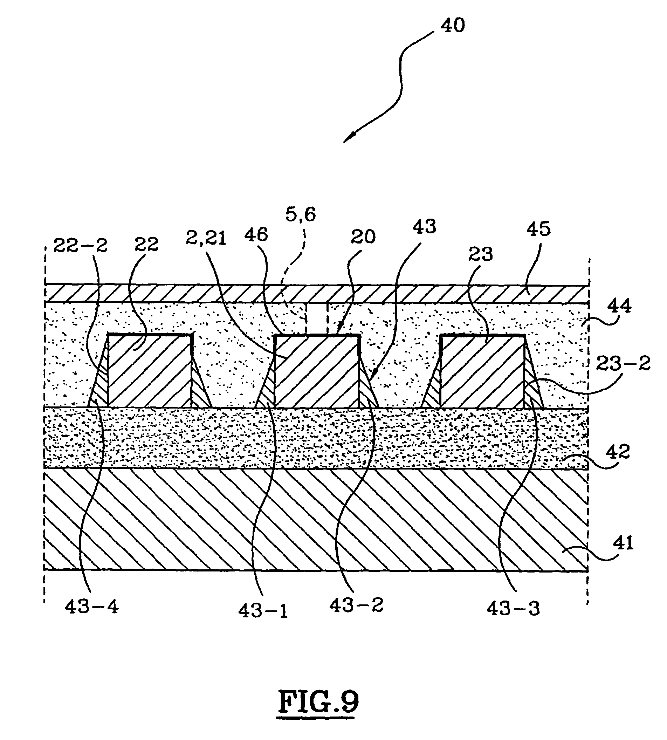

On va maintenant décrire en relation avec la figure 9 un autre avantage de ce mode de réalisation de l'invention, apparaissant lorsque le fusible est réalisé à partir d'une couche de polysilicium gravée au plasma. On rappelle ici que le polysilicium, même dopé, présente une conductivité médiocre, de sorte qu'il est nécessaire de prévoir un étape de siliciuration en présence d'un métal comme du titane Ti, du Cobalt Co, du Tungstène W, du Tantale Ta... Cette étape permet de déposer à la surface du polysilicium une couche de siliciure, par exemple du siliciure de titane $TiSi_2$, diminuant fortement la résistivité électrique du polysilicium.

La figure 9 est une vue partielle d'un circuit intégré 40 comprenant le fusible 20, vu en coupe selon un axe BB' représenté en figure 8. Dans un souci de clarté de la figure, les épaisseurs des divers éléments ne sont pas représentées à l'échelle. Le circuit intégré 40 comprend de façon classique un substrat 41, une première couche 42 d'oxyde épais, par exemple d'une épaisseur de 0,35 micromètre, une couche de polysilicium gravé formant le fusible 20, par exemple d'une épaisseur de 0,2 micromètre, une couche d'oxyde gravé 43, une deuxième couche 44 d'oxyde épais et une couche de métallisation 45 dans laquelle sont gravés des conducteurs. Les contacts 5,6, représentés en traits pointillés, sont classiquement des orifices métallisés reliant le fusible à la couche 45 ou toute autre métallisation prévue à un niveau supérieur. L'oxyde gravé 43 forme des monticules, ou "espaceurs d'oxyde" 43-1, 43-2 recouvrant les flancs de la région centrale 2 et de la partie amincie 21. Enfin, le fusible 20 est recouvert d'une couche de siliciure 46 permettant de diminuer dans de fortes proportions sa résistance électrique, comme on l'a déjà indiqué.

Comme cela est bien connu de l'homme de l'art, les espaceurs 43-1, 43-2 ne sont pas nécessaires à la réalisation du fusible et doivent leur existence au fait que le fusible est réalisé collectivement avec d'autres éléments du circuit intégré 40, par exemple des transistors MOS (non représentés). Toutefois, la présence des espaceurs 43-1, 43-2 sur les flancs du fusible 20 a pour effet négatif de limiter l'étendue de la couche de siliciure 46.

Ici, l'avantage de l'invention réside dans le fait que l'efficacité du processus de gravure de l'oxyde 43 est améliorée dans les zones où la région centrale 2 se trouve à proximité des éléments factices 22, 23. Ce phénomène, bien connu de l'homme de l'art, est appelé "effet de charge localisé". Le résultat apparaît clairement lorsque l'on compare les espaceurs 43-1, 43-2 présents sur les flancs de la zone amincie 21 avec, par exemple, des espaceurs 43-3, 43-4 présents sur des flancs externes 22-2, 23-2 des éléments factices 22, 23. On voit que les espaceurs 43-3, 43-4 recouvrent presque entièrement les flancs externes des éléments factices 22, 23 alors que les espaceurs 43-1, 43-2 ne recouvrent que partiellement les flancs de la zone amincie 21.

En définitive, la présence des éléments factices 22, 23 favorise la gravure de l'oxyde 43 sur les flancs du fusible et permet d'obtenir une couche de siliciure 46 plus étendue. La couche de siliciure 46 étant plus étendue, la résistance électrique du fusible est plus faible que celle d'un fusible classique de même dimension. Cet avantage améliore le rapport courant/tension du fusible et se cumule avec les autres avantages de l'invention pour l'obtention d'un bon rendement de claquage et une fiabilité élevée.

Il apparaîtra clairement à l'homme de l'art que la présente invention est susceptible de diverses variantes et modes de réalisation, notamment en ce qui concerne la dimension et la forme du fusible, le rapport entre la longueur L et la largeur W1 de la région centrale 2, l'agencement de la zone amincie 21, la largeur W2 de la zone amincie 21, l'agencement du fusible au sein d'un circuit intégré, les matériaux et les technologies utilisés pour la réalisation du fusible...

De façon générale, la présente invention permet d'obtenir, à encombrement de fusible identique et dans des conditions standard de claquage, une densité de courant plus élevée et une énergie de claquage plus importante, et permet par ailleurs de maîtriser la localisation du point d'éclatement d'un fusible. La prévision d'éléments factices agencés comme décrit plus haut est un aspect complémentaire de l'invention permettant de franchir les limites imposées par une technologie de fabrication.

En l'état actuel de la technologie, un fusible selon l'invention réalisé en polysilicium peut présenter une épaisseur de 0,2 micromètre pour une largeur moyenne de l'ordre de 0,25 micromètre, et un fusible réalisé en métal peut présenter une épaisseur de 0,5 micromètre pour une largeur de 0,4 micromètre.

**Revendications**

1. Procédé de réalisation par photolithographie de circuit intégré (40) disposant d'au moins un fusible (20) comprenant des plages (3,4) comportant des contacts électriques (5,6) et une région centrale (2) sensiblement en forme de barreau comportant une région amincie (21) formant un point faible facilitant le claquage du fusible par augmentation de la densité de courant (Ic) dans des conditions standards (Ic, Vc) de claquage, **caractérisé par** des étapes consistant à :

   - former un masque d'insolation reproduisant un dessin de fusible (D20) comportant la région centrale (D2) en forme de barreau, en disposant au moins un élément factice (D22) à proximité de la région centrale (D2) ayant un bord (D22-1) disposé, par rapport au bord correspondant de la région centrale (D2), à une distance (DE3) inférieure au seuil technologique (SEmin) en dessous duquel se manifeste l'effet optique de proximité, et
   - former, par insolation à travers le masque d'insolation, un masque de gravure de fusible (20) dont la région centrale (2) fait apparaître une zone amincie (21) par effet optique de proximité, de sorte que la largeur (W2) de la zone amincie est inférieure à un minimum technologique (Wmin) déterminé par la technologie de fabrication du circuit intégré.

2. Procédé selon la revendication 1, dans lequel chaque élément factice (D22,D23) a un bord (D22-1,D23-1) disposé, par rapport au bord correspondant de la région centrale (D2), à une distance (DE3) inférieure au seuil technologique (SEmin) en dessous duquel se manifeste l'effet optique de proximité.

3. Procédé selon la revendication 1 ou 2, dans lequel la région centrale (D2) du dessin de fusible (020) a une largeur (OW1) choisie pour obtenir une largeur (W1) de fusible (20) sensiblement égale au minimum technologique (Wmin), en dehors de la zone amincie.

4. Procédé selon l'une des revendications 1 à 3, dans lequel la largeur (W2) de la zone amincie (21) est sensiblement égale à la moitié de la largeur moyenne (W1) de la région centrale (2) en dehors de la zone amincie.

5. Procédé selon l'une des revendications 1 à 4, dans lequel l'effet optique de proximité forme un amincissement progressif de la région centrale (2).

6. Procédé selon l'une des revendications 1 à 5, dans lequel l'effet optique de proximité forme, entre la région centrale (2) et la zone amincie (21), des transitions d'amincissement présentant des bords obliques.

7. Procédé selon l'une des revendications 1 à 6, dans lequel sur le dessin de fusible (D20), on dispose deux éléments factices (D22,D23) de part et d'autre de la région centrale (D2).

8. Procédé selon l'une des revendications 1 à 7, dans lequel il est prévu de former deux encoches (21-1,21-2) sur les flancs de la région centrale (2) du fusible (20).

9. Procédé selon l'une des revendications 1 à 8, dans lequel, en utilisant l'effet optique de proximité, le masque de gravure de fusible (20) présente au moins une ouverture de gravure de largeur (E2) supérieure à la largeur (DE2, DE3) d'espacement entre les éléments prévue sur le dessin (D20) de fusible du masque d'insolation.

10. Procédé selon l'une des revendications 1 à 9, dans lequel le masque de gravure (32) est obtenu par dépôt d'une couche de résine photosensible sur une couche (31) du circuit intégré, suivi d'une étape d'insolation de la résine par l'intermédiaire du masque d r insolation et d'une étape de retrait de la résine insolée au moyen d'un solvant.

11. Procédé selon l'une des revendications 1 à 10 dans lequel le fusible (20) de circuit intégré (40) est réalisé par gravure d'une couche mince de polysilicium, de métal ou d'alliage, ou encore par gravure d'une couche mince formée d'un empilement de métaux ou d'alliages.

12. Procédé selon l'une des revendications 1 à 11 dans lequel le fusible (20) de circuit intégré (40) est réalisé en polysilicium siliciuré (46).

13. Procédé selon l'une des revendications 1 à 12, comportant une étape de gravure au plasma.

14. Procédé selon l'une des revendications 1 à 13, dans lequel la disposition d'éléments factices (22,23) favorise la gravure d'une couche d'oxyde (43) sur les flancs du fusible (40), de sorte que le fusible présente des espaceurs d'oxyde (43-1,43-2) ne recouvrant pas entièrement les flancs de la zone amincie (2,21).

**Patentansprüche**

1. Verfahren zur Herstellung durch Photolithographie einer integrierten Schaltung (40), die über zumindest eine Schmelzsicherung (20) verfügt, mit Bereichen (3, 4), welche elektrische Kontakte (5, 6) aufweisen, und einem praktisch stabförmigen, zentralen Bereich (2), der einen verengten Bereich (21) aufweist, welcher einen schwachen Punkt bildet, der das Durchschlagen der Schmelzsicherung durch Erhöhung der Stromdichte (Ic) unter Standarddurchschlagsbedingungen (Ic, Vc) erleichtert, **gekennzeichnet durch** Schritte, die daraus bestehen:

   - eine Isolierungsmaske zu bilden, welche ein Schmelzsicherungsmuster (D20) mit dem stabförmigen, zentralen Bereich (D2) reproduziert, indem zumindest ein Scheinelement (D22) in der Nähe des zentralen Bereiches (D2) angeordnet wird, wobei eine Kante (D22-1) bezüglich der entsprechenden Kante des zentralen Bereiches (D2) mit einem kleineren Abstand (DE3) als der technologische Schwellenwert (SEmin) angeordnet wird, unterhalb welchem sich der optische Nachbarschaftseffekt ereignet, und
   - **durch** Isolierung **durch** die Isolierungsmaske hindurch eine Gravurmaske für die Schmelzsicherung (20) zu bilden, deren zentraler Bereich (2) **durch** optischen Nachbarschaftseffekt einen verengten Bereich (21) entstehen lässt, so dass die Breite (W2) des verengten Bereiches kleiner als das von der Herstellungstechnologie für integrierte Schaltungen festgelegte technologische Minimum (Wmin) ist.

2. Verfahren gemäß Anspruch 1, bei welchem jedes Scheinelement (D22, D23) eine Kante (D22-1, D23-1) aufweist, die bezüglich der entsprechenden Kante des zentralen Bereiches (D2) mit einem kleineren Abstand als der technologische Schwellenwert (SEmin) angeordnet ist, unterhalb welchem der optische Nachbarschaftseffekt eintritt.

3. Verfahren gemäß Anspruch 1 oder 2, bei welchem der zentrale Bereich (D2) des Schmelzsicherungsmusters (D20) eine derart gewählte Breite (DW1) aufweist, dass eine Breite (W1) der Schmelzsicherung (20) erhalten wird, die praktisch gleich dem technologischen Minimum (Wmin) außerhalb des verengten Bereiches ist.

4. Verfahren gemäß einem der Ansprüche 1 bis 3, bei welchem die Breite (W2) des verengten Bereiches (21) praktisch gleich der Hälfte der mittleren Breite (W1) des zentralen Bereiches (2) außerhalb des verengten Bereiches ist.

5. Verfahren gemäß einem der Ansprüche 1 bis 4, bei welchem der optische Nachbarschaftseffekt eine zunehmende Verengung des zentralen Bereiches (2) bildet.

6. Verfahren gemäß einem der Ansprüche 1 bis 5, bei welchem der optische Nachbarschaftseffekt zwischen dem zentralen Bereich (2) und dem verengten Bereich (21) Verengungsübergänge ausbildet, welche schräge Kanten aufweisen.

7. Verfahren gemäß einem der Ansprüche 1 bis 6, bei welchem an dem Schmelzsicherungsmuster (D20) zwei Scheinelemente (D22, D23) beidseits von dem zentralen Bereich (D2) angeordnet werden.

8. Verfahren gemäß einem der Ansprüche 1 bis 7, bei welchem vorgesehen ist, zwei Kerben (21-1, 21-2) an den Flanken des zentralen Bereiches (2) der Schmelzsicherung (20) auszubilden.

9. Verfahren gemäß einem der Ansprüche 1 bis 8, bei welchem unter Einsatz des optischen Nachbarschaftseffektes die Gravurmaske für die Schmelzsicherung (20) zumindest eine Gravuröffnung mit einer größeren Breite (E2) aufweist als die Abstandsbreite (DE2, DE3) zwischen den an dem Schmelzsicherungsmuster (D20) der Isolierungsmaske vorgesehenen Elementen.

10. Verfahren gemäß einem der Ansprüche 1 bis 9, bei welchem die Gravurmaske (32) durch Aufbringen einer lichtempfindlichen Harzschicht auf eine Schicht (31) der integrierten Schaltung, gefolgt von einem Isolierungsschritt des Harzes mit Hilfe der Isolierungsmaske und einem Schritt des Schrumpfens des isolierten Harzes mit Hilfe eines Lösemittels, erhalten wird.

11. Verfahren gemäß einem der Ansprüche 1 bis 10, bei welchem die Schmelzsicherung (20) der integrierten Schaltung (40) durch Gravur einer dünnen Schicht aus Polysilicium, aus Metall oder aus einer Legierung oder auch durch Gravur einer dünnen Schicht hergestellt wird, die aus einer Aufeinanderschichtung von Metallen oder Legierungen gebildet ist.

12. Verfahren gemäß einem der Ansprüche 1 bis 11, bei welchem die Schmelzsicherung (20) der integrierten Schaltung (40) aus einem silicidierten Polysilicium (46) hergestellt ist.

13. Verfahren gemäß einem der Ansprüche 1 bis 12 mit einem Schritt der Plasmagravur.

14. Verfahren gemäß einem der Ansprüche 1 bis 13, bei welchem die Anordnung von Scheinelementen (22, 23) die Gravur einer Oxidschicht (43) auf den Flanken der Schmelzsicherung (40) begünstigt, so dass die Schmelzsicherung Oxidabstandshalter (43-1, 43-2) aufweist, welche die Flanken des verengten Bereiches (2, 21) nicht vollständig abdekken.

## Claims

**1.** Photolithographic method of producing an integrated circuit (40) having at least one fuse (20) comprising areas (3, 4) having electrical contacts (5, 6) and a central region (2) substantially in the form of a bar that includes a thinned region (21) forming a weak point making it easier for the fuse to blow by increasing the current density ($I_b$) under standard blowing conditions ($I_b$, $V_b$) **characterized by** steps consisting:

- in forming an exposure mask reproducing a fuse pattern (D20) having the bar-shaped central region (D2), by placing, near the central region (D2), at least one dummy element (D22) having an edge (D22-1) lying, relative to the corresponding edge of the central region (D2), at a distance ($DE_3$) of less than the technological threshold ($SE_{min}$) below which the optical proximity effect is manifested; and
- in forming, by exposure through the exposure mask, a fuse etching mask (20), the central region (2) of which reveals a thinned zone (21) formed by the optical proximity effect, so that the width ($W_2$) of the thinned zone is less than a technological minimum ($W_{min}$) determined by the technology used to fabricate the integrated circuit.

**2.** Process according to Claim 1, in which each dummy element (D22, D23) has an edge (D22-1, D23-1) lying, relative to the corresponding edge of the central region (D2), at a distance ($DE_3$) of less than the technological threshold ($SE_{min}$) below which the optical proximity effect is manifested.

**3.** Method according to Claim 1 or 2, in which the central region (D2) of the fuse pattern (D20) has a width ($OW_1$) that is chosen so as to obtain a width ($W_1$) of the fuse (20) substantially equal to the technological minimum ($W_{min}$) outside the thinned zone.

**4.** Method according to one of Claims 1 to 3, in which the width ($W_2$) of the thinned zone (21) is substantially equal to half of the mean width ($W_1$) of the central region (2) outside the thinned zone.

**5.** Method according to one of Claims 1 to 4, in which the optical proximity effect forms a progressive thinning of the central region (2).

**6.** Method according to one of Claims 1 to 5, in which the optical proximity effect forms, between the central region (2) and the thinned zone (21), thinning transitions having oblique edges.

**7.** Method according to one of Claims 1 to 6, in which two dummy elements (D22, D23) are placed on either side of the central region (D2) on the fuse pattern (D20).

**8.** Method according to one of Claims 1 to 7, in which provision is made to form two notches (21-1, 21-2) on the side walls of the central region (2) of the fuse (20).

**9.** Method according to one of Claims 1 to 8, in which, by using the optical proximity effect, the mask for etching the fuse (20) has at least one etching aperture of width ($E_2$) greater than the spacing width ($DE_2$, $DE_3$) between the elements provided on the fuse pattern (D20) of the exposure mask.

**10.** Method according to one of Claims 1 to 9, in which the etching mask (32) is obtained by depositing a layer of photoresist on a layer (31) of the integrated circuit, followed by a step of exposing the photoresist through the exposure mask and by a step of removing the exposed photoresist by means of a solvent.

**11.** Method according to one of Claims 1 to 10, in which the fuse (20) of the integrated circuit (40) is produced by etching a thin layer of polysilicon, metal or alloy, or else by etching a thin layer formed from a stack of metals or alloys.

**12.** Method according to one of Claims 1 to 11, in which the fuse (20) of the integrated circuit (40) is made of silicided polysilicon (46).

**13.** Method according to one of Claims 1 to 12, which includes a plasma etching step.

**14.** Method according to one of Claims 1 to 13, in which the arrangement of dummy elements (22, 23) favours the etching of an oxide layer (43) on the side walls of the fuse (40), so that the fuse has oxide spacers (43-1, 43-2) that do not entirely cover the side walls of the thinned zone (2, 21).

1
3
4
5
2
6
A
W
A'

FIG.1

10
5
3
14
2
1
4
6
15
12
11
13

FIG.2

20
3
4
5
2
21
6
FIG.3
W1
W2
L
Ic
Rt
Vc
Ra1
R1
R2
R3
Ra2
FIG.4
DE2
D31
DE1
D31
FIG.5A
FIG.6A
D30
D30
33
ME1
32
31
FIG.5B
FIG.6B
31
32
33
ME2
E1
31
FIG.5C
FIG.6C
30
31
30
E2

20
22−1
4
23−1
23
22
B
B'
E3
W2 <Wmin
21−1
21
W1=Wmin
21−2
2
3
D20
D4
D22
D23
DE3
DW1
D2
D22−1
D23−1
D3

FIG.8

FIG.7

40

22-2
22
2,21
46
5,6
20
43
45
23
44
23-2
42
41
43-4
43-1
43-2
43-3

FIG.9